# EUROPÄISCHE PATENTSCHRIFT

(11) **EP 0 754 304 B1**
(45) Veröffentlichungstag und Bekanntmachung des Hinweises auf die Patenterteilung: **29.12.1997**
(21) Anmeldenummer: 95913895.9
(22) Anmeldetag: 01.04.1995
(51) Int. Cl.: G01R 31/02

(54) **ANORDNUNG ZUR PRÜFUNG DES ISOLATIONSZUSTANDES VON AN WECHSELSPANNUNG LIEGENDEN LEITUNGEN ODER KABELN**
DEVICE FOR CHECKING THE INSULATION CONDITION OF ALTERNATING-CURRENT-CARRYING LINES OR CABLES
SYSTEME PERMETTANT DE VERIFIER L'ISOLATION DE LIGNES ET DE CABLES SOUS TENSION ALTERNATIVE

(30) Priorität: 07.04.1994 DE 4412250
(43) Veröffentlichungstag der Anmeldung: 22.01.1997
(73) Patentinhaber: ABB Daimler-Benz Transportation (Technology) GmbH, 13627 Berlin (DE)
(72) Erfinder: XIE, Jian, D-63225 Langen (DE); OHRBAND, Werner, D-63225 Langen (DE)
(74) Vertreter: Rupprecht, Klaus, Dipl.-Ing.
(86) Internationale Anmeldenummer: EP9501219
(87) Internationale Veröffentlichungsnummer: WO9527904

(56) Entgegenhaltungen:
- EP-A- 0 534 113
- EP-A- 0 555 946
- WO-A-92/18872

## Beschreibung

Die Erfindung bezieht sich auf eine Streckenprüfeinrichtung zur Prüfung des Isolationszustandes von an Wechselspannung liegenden Bahnfahrleitungen, wie sie im Oberbegriff des Anspruches 1 näher definiert ist. Eine solche Streckenprüfeinrichtung ist durch die EP 0 555 946 A2 bekannt.

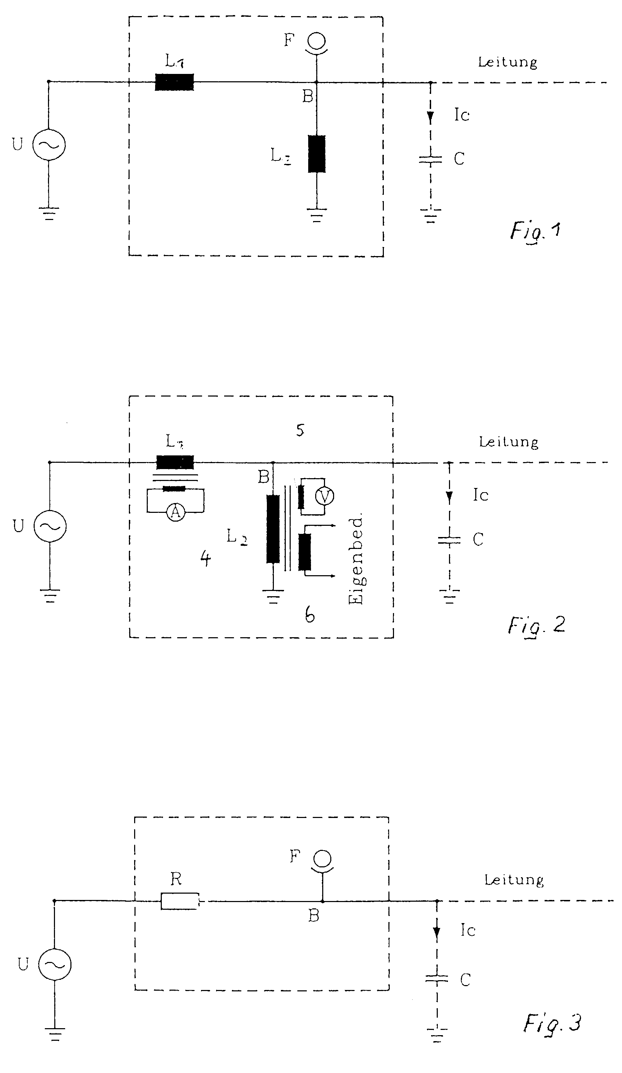

Kurzschlüsse auf Leitungsstrecken, insbesondere Bahnleitungsstrecken, können verschiedene Ursachen haben, die teils auf die anliegenden Verbraucher (Fahrzeuge) zurückzuführen sind, aber teils auch an den Fahrleitungen selbst liegen können. Der Isolationswiderstand von Fahrleitungen wird deshalb nach Kurzschlüssen geprüft. Es ist dazu bekannt, eine Prüfeinrichtung elektrisch seriell in die Strecke einzuschalten. Eine solche bekannte Anordnung zeigt z.B. Fig. 3. Die Fahrleitung wird dort von einer an Erde liegenden Spannungsquelle U gespeist. Die eigentliche Prüfeinrichtung ist gestrichelt umrahmt und besteht aus einem Prüfwiderstand R und einem nachgeschalteten Spannungswandler F. Liegt an der Leitungsstrecke ein Kurzschluß vor, bricht am Punkt B die Spannung zusammen, was mit Hilfe des Spannungswandlers F am Punkt B festgestellt werden kann. Über den Prüfwiderstand R wird der Prüfstrom begrenzt. Eine solche Anordnung ist nur funktionstüchtig, wenn der kapazitive Ladestrom Ic der Fahrleitung kleiner ist als der Prüfstrom. Bei Einsatz von langen Kabeln oder langen Fahrleitungen wird die Kapazität C entsprechend größer und damit erhöht sich auch der kapazitive Ladestrom Ic. Der Prüfwiderstand muß in einem solchen Fall für höheren Prüfstrom und höhere Leistung ausgelegt werden. Das führt zu erheblichen Erwärmungsproblemen, außerdem erhöhen sich stark Volumen und Kosten des Prüfwiderstandes. Hinzu kommen unter Umständen noch Probleme hinsichtlich eines Ersatzes bisher verwendeter umweltschädlicher Stoffe bei der Herstellung solcher Widerstände, wie z.B. Asbest.

Es ist bereits durch die eingangs angegebene EP 0 555 946 A2, Fig. 2 bekannt, den Prüfwiderstand R durch eine Drossel zu ersetzen, wobei die Aufgabe des Prüfwiderstandes, d.h. die Begrenzung des Prüfstroms, von der Drosselinduktivität übernommen wird. Unbefriedigend hierbei ist, daß durch die Reihenschaltung der Drossel und der Fahrleitungskapazität C ein Reihenschwingkreis entsteht, der eine Spannungserhöhung am Punkt B verursacht, was in extremen Fällen zur Zerstörung von Geräten in der Schaltanlage und im Oberleitungsnetz führen kann. Diese Spannungserhöhung ist umso größer, je größer die Fahrleitungskapazität und je größer die Induktivität der Drossel ist. Bei größerer Leitungskapazitäten müssen zur Vermeidung zu großer Spannungserhöhungen Drosseln mit an sich zu kleinen Induktivitäten verwendet werden. Dies führt wiederum zu einem hohen Prüfstrom, der Schaden an der Kurzschlußstelle verursachen kann. Außerdem muß die Drossel für den hohen Nennstrom dimensioniert werden. Die Kosten und das Volumen der Drossel sind dadurch erheblich, das Ganze unbefriedigend.

Es ist auch gemäß der zuvor erwähnten EP 0 555 946 A2, Fig. 1 bereits versucht worden, die durch Reihenschaltung von Drossel und Fahrleitungskapazität verursachten Spannungserhöhungen dadurch zu mindern, daß man anstelle einer Drossel einen Transformator verwendet, dessen Sekundärseite an Kondensatoren angeschlossen und über Schalter kurzschließbar ist. Der Schalter ist bevorzugt als schneller Schalter aus der Leistungselektronik realisiert und dient der Strombegrenzung. Diese Art Prüfeinrichtung wirkt kapazitiv wie ein zwischen Oberleitung und Stromversorgungseinrichtung geschalteter Hochspannungskondensator.

Durch die EP 0 534 113 A2 ist eine Anordnung zur schnellen Erkennung von Kurzschlüssen in einem Niederspannungsnetz während des Betriebes bekannt, bei der in eine der beiden Leitungen ein Stromwandler und zwischen beide Leitungen ein Spannungswandler geschaltet ist. Strom- und Spannungswandler sind sekundärseitig an eine Auswerteschaltung gelegt, durch die die Realteile sowie die Beträge der komplexen Leistung, die komplexen Leitwerte und der Leistungsfaktor ermittelt werden. Die ermittelten Leistungen und Leitwerte sowie der Leistungsfaktor werden zu einem Entscheidungsvektor zusammengefaßt, der bei Überschreiten eines Grenzwertes einen Abschaltbefehl für das Netz auslöst. Eine Bemessungsgrundlage für die Primärwicklung des Spannungswandlers ist nicht angegeben.

Aufgabe der Erfindung ist es, eine Streckenprüfungseinrichtung zur Prüfung des Isolationszustandes zu schaffen, mit der die geschilderten Probleme auf einfachere Weise vermieden werden können und mit der insbesondere die Spannungserhöhungen weitgehend ausgeschaltet und kleine Baugrößen der Strombegrenzungsmittel eingesetzt werden können.

Diese Aufgabe wird gemäß den kennzeichnenden Merkmalen des Anspruches 1 gelöst.

Vorteilhafte Ausgestaltungen sind den Unteransprüchen entnehmbar.

Anhand von schematischen Ausführungsbeispielen wird die Erfindung im nachstehenden näher erläutert.

Es zeigen:
- Fig. 1: eine Anordnung mit einer strombegrenzenden Drosselspule und einer Kompensationsdrossel
- Fig. 2: eine Anordnung mit Drosselspulen und Zusatzwicklungen
- Fig. 3: Stand der Technik mit Prüfwiderstand.

Auf den Stand der Technik gemäß Fig. 3 wurde schon eingegangen. Nach der Erfindung - auch hier ist die eigentliche Prüfeinrichtung wieder gestrichelt umrahmt - wird jetzt entsprechend Fig. 1 anstelle einer bloßen Drosselspule L₁ zusätzlich eine Kompensationsdrossel L₂ verwendet, mit der die Fahrleitungskapazität C kompensiert wird. Der Spannungswandler F am Punkt B hat dabei wie nach Fig. 3 dieselbe Funktion als Spannungsmeßglied. Bei einer totalen Kompensation oder bei Überkompensation, entsprechend ω² · L₂ · C ≤ 1 kann so eine Spannungserhöhung an Meßpunkt B vermieden werden. Von Vorteil ist, daß die Drosselspule L₁ nur für die Begrenzung des Prüfstromes dimensioniert zu werden braucht und damit wesentlich kleiner gehalten werden kann.

Fig. 2 zeigt dann noch eine weitere Möglichkeit, bei der den Drosselspulen L₁ und L₂ zusätzliche Wicklungen (4, 5) für Meßzwecke zugeordnet sind, wodurch einmal der zusätzliche Spannungswandler F dann entfallen kann. Über die Wicklung 4 ist eine Strommeßung möglich. Die Kompensationsdrossel L₂ ist darüberhinaus noch mit einer Wicklung 6 für die Versorgung des Eigenbedarfs versehen.

## Patentansprüche

1. Streckenprüfeinrichtung zur Prüfung des Isolationszustandes von an Wechselspannung liegenden Bahnfahrleitungen nach einem Kurzschluß, die zur Prüfung zwischen der Betriebs-Wechselspannungsquelle (U) und den zu prüfenden Streckenabschnitt geschaltet ist und die eine Drosselspule (L₁) zur Strombegrenzung bei Prüfeinspeisung sowie einen nachgeschalteten an einem inneren Meßpunkt die auftretende Spannung zwischen Prüfstrecke und Erde erfassenden Spannungswandler (F) enthält,
**dadurch gekennzeichnet,**
daß der Drosselspule (L₁) zusätzlich innerhalb der Prüfeinrichtung eine zwischen Fahrleitungsanschluß und Erde (bei Meßpunkt B) quergeschaltete Kompensationsdrosselspule (L₂) zugeordnet ist, die zur Kompensation oder Überkompensation der Leitungskapazität (C) entsprechend der Formel ω² · L₂ · C ≤ 1 ausgelegt ist, wobei ω die Kreisfrequenz der Wechselspannung ist.

2. Streckenprüfeinrichtung nach Anspruch 1,
**dadurch gekennzeichnet,**
daß die Kompensationsdrosselspule (L₂) als Primärwicklung des Spannungswandlers dient und dazu mit einer Zusatzwicklung als Sekundärwicklung des Spannungswandlers (F) versehen ist.

3. Streckenprüfeinrichtung nach Anspruch 2,
**dadurch gekennzeichnet,**
daß die Kompensationsdrosselspule (L₂) mit einer weiteren Wicklung (6) für eine Versorgung des Eigenbedarfs versehen ist.

## Claims

1. Line-section testing device for testing the insulation condition of railway overhead-contact lines, which have AC voltage applied to them, after a short circuit, which device is connected, for the purpose of testing, between the operating AC voltage source (U) and the line section to be tested and contains an inductor (L₁) for current limiting in the event of test feed-in as well as a downstream voltage transformer (F), which detects the voltage occurring between the section to be tested and earth at an internal measuring point, characterized in that the inductor (L₁) is additionally assigned, within the test device, a compensation inductor (L₂) which is cross-connected between the overhead-contact line terminal and earth (at measuring point B) and is designed to compensate for or overcompensate for the line capacitance (C) in accordance with the formula ω² · L₂ · C≤1, where ω is the angular frequency of the AC voltage.

2. Line-section testing device according to Claim 1, characterized in that the compensation inductor (L₂) serves as the primary winding of the voltage transformer and to that end is provided with an additional winding as the secondary winding of the voltage transformer (F).

3. Line-section testing device according to Claim 2, characterized in that the compensation inductor (L₂) is provided with a further winding (6) for supplying its own requirements.

## Revendications

1. Dispositif de contrôle de ligne pour le contrôle de l'isolation de caténaires alimentées en tension alternative après un court-circuit, lequel dispositif, pour le contrôle, est connecté entre la source de travail (U) à tension alternative et le tronçon de ligne à contrôler et comporte une bobine de self-induction (L₁) pour limiter le courant lors de l'alimentation de contrôle ainsi qu'un transformateur de tension (F) qui est branché à la suite de celle-ci, en un point de mesure interne, et mesure la tension entre la ligne à contrôler et la terre, caractérisé par le fait qu'une bobine de self-induction (L₂) de compensation connectée transversalement entre le point de connexion à la caténaire et la terre (point de mesure B) est associée à la bobine de self-induction (L₁) à l'intérieur du dispositif de contrôle, laquelle bobine de self-induction est calculée pour compenser ou surcompenser la capacité de ligne (C) conformément à la formule ω² . L₂ . C ≤ 1, ω représentant la fréquence de la tension alternative.

2. Dispositif de contrôle de ligne selon la revendication 1, caractérisé par le fait que la bobine de self-induction (L₂) de compensation sert d'enroulement primaire du transformateur de tension et est pourvue à cet effet d'un enroulement supplémentaire, en tant qu'enroulement secondaire du transformateur de tension (F).

3. Dispositif de contrôle de ligne selon la revendication 2, caractérisé par le fait que la bobine de self-induction (L₂) de compensation est pourvue à cet effet d'un enroulement (6) supplémentaire pour la couverture des besoins propres.
